# EUROPÄISCHE PATENTSCHRIFT

(11) **EP 1 997 156 B1**
(45) Veröffentlichungstag und Bekanntmachung des Hinweises auf die Patenterteilung: **17.07.2013**
(21) Anmeldenummer: 07723432.6
(22) Anmeldetag: 20.03.2007
(51) Int. Cl.: H01L 31/18, H01L 21/00

(54) **VERFAHREN ZUR HERSTELLUNG EINES HALBLEITERBAUELEMENTES MIT EINEM GEZIELT DOTIERTEN OBERFLÄCHENBEREICH UNTER VERWENDUNG VON AUS-DIFFUSION UND ENTSPRECHENDES HALBLEITERBAUELEMENT**
METHOD FOR FABRICATING A SEMICONDUCTOR COMPONENT WITH A SPECIFICALLY DOPED SURFACE REGION USING OUT-DIFFUSION, AND CORRESPONDING SEMICONDUCTOR COMPONENT
PROCÉDÉ DE FABRICATION D'UN COMPOSANT SEMI-CONDUCTEUR AVEC UNE ZONE DOPÉE SUPERFICIELLE CIBLÉE AU MOYEN DE LA DIFFUSION ET COMPOSANT SEMI-CONDUCTEUR CORRESPONDANT

(30) Priorität: 21.03.2006 DE 102006013313
(43) Veröffentlichungstag der Anmeldung: 03.12.2008
(73) Patentinhaber: Institut für Solarenergieforschung GmbH, 31860 Emmerthal (DE)
(72) Erfinder: BRENDEL, Rolf, 31789 Hameln (DE); TERHEIDEN, Barbara, 31787 Hameln (DE); WOLF, Andreas, 64367 Mühltal (DE)
(74) Vertreter: Kühn, Ralph
(86) Internationale Anmeldenummer: PCT/EP2007/002468
(87) Internationale Veröffentlichungsnummer: WO 2007/107339

(56) Entgegenhaltungen:
- EP-A2- 0 528 229
- US-A- 5 854 123
- US-A1- 2003 087 503
- US-A1- 2003 203 547
- US-B1- 6 326 280

## Beschreibung

### BEREICH DER ERFINDUNG

Die vorliegende Erfindung betrifft ein Verfahren zur Herstellung eines Halbleiterbauelementes mit einem gezielt dotierten Oberflächenbereich und ein entsprechendes Halbleiterbauelement. Insbesondere betrifft die vorliegende Erfindung die Herstellung eines Halbleiterbauelements wie z.B. einer Dünnschicht-Solarzelle unter Verwendung eines Schichttransfer-Verfahrens.

### HINTERGRUND DER ERFINDUNG

Das Einbringen von Dotierstoffen in Halbleitermaterialien ist ein wesentlicher Bestandteil der Fertigung von Halbleiterbauelementen. Zur Herstellung eines gezielt dotierten Bereichs in einem Halbleiterbauelement wie zum Beispiel eines Emitters für eine Solarzelle ist normalerweise ein von der sonstigen Sequenz zur Herstellung des Halbleiterbauelements unabhängiger Prozess notwendig. Beispielsweise kann eine in einem Bor-dotierten Halbleitersubstrat als Emitter dienende phosphordotierte Schicht durch POCl₃-Diffusion erzeugt werden.

Um den Bedarf an teurem Halbleitermaterial zu reduzieren, werden Halbleiterbauelemente häufig unter Verwendung von Dünnschichttechnologien gefertigt. Dabei werden dünne Halbleiterschichten auf einem Trägersubstrat abgeschiedenen , z.B. durch Gasphasenabscheidung (CVD). Hierbei besteht die Möglichkeit, während des Wachstums einer Schicht Art und Konzentration der Dotierung zu ändern, und so ein aus mehreren unterschiedlich dotierten Schichten bestehendes Halbleiterbauelement herzustellen. Dazu ist für jede einzelne Schicht je ein Prozessschritt mit spezifischen Parametern z.B. für die Zusammensetzung der Gasphase bei der CVD-Abscheidung nötig. Zusätzlich können Zwischenschritte z.B. zum Spülen des CVD-Reaktors und Ändern der Gasflüsse und / oder ein Wechsel des Reaktors notwendig sein. Die Dokumente US 6,326,280 B1 und US 5,854,123 beschrieben Herstellungsverfahren für Solarzellen.

### ZUSAMMENFASSUNG DER ERFINDUNG

Es kann ein Bedarf dafür bestehen, ein vereinfachtes Herstellungsverfahren für ein Halbleiterbauelement bereitzustellen, bei dem möglichst wenige Prozessierungsschritte erforderlich sind und/oder ein Ändern von Prozessparametern während des Abscheidens einer dünnen Halbleiterschicht, die für das Halbleiterbauelement verwendet wird, vermieden werden kann.

Dieser Bedarf kann durch den Gegenstand der unabhängigen Ansprüche erfüllt werden. Vorteilhafte Ausführungsformen der vorliegenden Erfindung sind in den abhängigen Ansprüchen beschrieben.

Gemäß einem ersten Aspekt der vorliegenden Erfindung wird ein Verfahren zum Herstellen eines Halbleiterbauelementes mit einem gezielt dotierten Oberflächenbereich vorgeschlagen, wobei das Verfahren die folgenden Schritte aufweist: Bereitstellen eines dotierten Halbleiterträgersubstrats; Erzeugen einer Trennschicht an einer Oberfläche des Halbleiterträgersubstrats; Abscheiden einer dotierten Halbleiterschicht über der Trennschicht; und Lösen der abgeschiedenen Halbleiterschicht von dem Halbleiterträgersubstrat. Eine solche Prozesssequenz kann als Schichttransfer Prozess bezeichnet werden. Die während des Herstellungsverfahrens verwendeten Prozessparameter werden hierbei so gewählt, dass Dotanden aus der Trennschicht in die abgeschiedene Halbleiterschicht diffundieren, um den gezielt dotierten Oberflächenbereich zu bilden.

Merkmale, Einzelheiten und mögliche Vorteile des erfindungsgemäßen Herstellungsverfahrens werden im Anschluss erläutert.

Unter einem Halbleiterbauelement kann ein elektronisches Bauelement verstanden werden, das auf einem Halbleitersubstrat basiert, in dessen Oberfläche gezielt dotierte Bereiche eingebracht sind. Das Halbleitersubstrat kann hierbei in Form einer dünnen Halbleiterschicht beispielsweise mit einer Dicke von weniger als 50 µm, vorzugsweise weniger als 10 µm und stärker bevorzugt zwischen 1 und 5 µm ausgebildet sein. Beispielsweise kann das herzustellende Halbleiterbauelement eine Dünnschicht-Solarzelle sein.

Zur Herstellung des Halbleiterbauelements wird zunächst ein dotiertes Halbleiterträgersubstrat bereitgestellt. Das Halbleiterträgersubstrat kann ein vorzugsweise flächiges Substrat vorzugsweise aus Silizium, insbesondere bevorzugt aus einkristallinem Silizium, sein. Beispielsweise kann als Halbleiterträgersubstrat ein stark dotierter monokristalliner Siliziumwafer verwendet werden.

An einer Oberfläche des Halbleiterträgersubstrats kann eine Trennschicht erzeugt werden, die eine Sollbruchstelle bei dem späteren Ablösen der Halbleiterschicht von dem Halbleiterträgersubstrat darstellen kann. Die Trennschicht kann beispielsweise als eine poröse Schicht oder als ein Schichtsystem aus mehreren übereinanderliegenden porösen Schichten beispielsweise durch anodisches Ätzen erzeugt werden. Hierbei werden kleine Hohlräume in die Oberfläche des Halbleiterträgersubstrats geätzt, sodass sich eine schwammartige, poröse und relativ instabile Schicht bildet, die nachfolgend als Sollbruchstelle zwischen dem Halbleiterträgersubstrat und einer auf diesem abzuscheidenden Halbleiterschicht dienen kann. Ein möglicher Ätzvorgang zum Erzeugen einer porösen Schicht in einem Siliziumwafer ist in der DE 197 30 975 A1 beschrieben.

Alternativ kann die Trennschicht beispielsweise auch dadurch erzeugt werden, dass durch Ionenimplantation gezielt eine Schicht in einem gewissen Abstand unterhalb der Oberfläche des Halbleiterträgersubstrates geschwächt wird, so dass sie später als Sollbruchstelle dienen kann.

Über die Trennschicht wird dann eine dotierte Halbleiterschicht abgeschieden. Die Halbleiterschicht kann dabei direkt an die Trennschicht angrenzen. Alternativ kann auch eine Zwischenschicht, beispielsweise aus einem Dielektrikum, zwischen die Trennschicht und die Halbleiterschicht zwischengelagert sein. Die Halbleiterschicht kann zum Beispiel mittels Gasphasenepitaxie (CVD - chemical vapour deposition), Flüssigphasenepitaxie (LPE - liquid phase epitaxy) oder Ionen-assistierter Abscheidung (IAD - ion assisted deposition) abgeschieden werden. Dem abzuscheidenden Halbleitermaterial können dabei während der Abscheidung Dotierstoffe beigemengt sein, sodass sich bei der Abscheidung eine dotierte Halbleiterschicht mit einer vorbestimmten Dotandenkonzentration erreichen lässt.

Prozessparameter wie zum Beispiel eine Prozesstemperatur während des Abscheidens der dotierten Halbleiterschicht oder während eines optionalen nachträglichen Temperaturbehandlungsschrittes nach dem Abscheiden der dotierten Halbleiterschicht und diesbezügliche Prozessdauern werden erfindungsgemäß so gewählt, dass Dotanden, die ursprünglich aus dem Halbleiterträgersubstrat bzw. aus der Trennschicht stammen, in die abgeschiedene Halbleiterschicht diffundieren. Dies kann direkt während des Abscheidens der dotierten Halbleiterschicht oder in einem sich anschließenden optionalen Temperaturbehandlungsschritt erfolgen. Geeignete Prozessparameter wie die Prozesstemperatur bzw. einen Temperaturverlauf und die Prozessdauer, um einen gezielt dotierten Oberflächenbereich mit einer gewünschten Dotandenkonzentration und einem gewünschten Dotandenprofil zu erreichen, können zum Beispiel durch geeignete Versuchsreihen, wie sie dem Fachmann ersichtlich sind, oder auch durch Computersimulationen des Diffusionsvorgangs bestimmt werden.

Wenn mittels des erfindungsgemäßen Herstellungsverfahrens zum Beispiel eine Dünnschicht-Silizium-Solarzelle hergestellt werden soll, können die Prozessparameter so gewählt werden, dass in dem gezielt dotierten Oberflächenbereich eine Emitterschicht mit einem Schichtwiderstand von weniger als 500 Ohm/square, vorzugsweise weniger als 350 Ohm/square und stärker bevorzugt weniger als 200 Ohm/square gebildet wird. Mit einem solchen, im Vergleich zur restlichen Halbleiterschicht verhältnismäßig stark dotierten Emitter lassen sich Serienwiderstände innerhalb des Emitters und damit verbundene Leistungsverluste für die Solarzelle minimieren.

Dem erfindungsgemäßen Verfahren liegt die Idee zugrunde, für die oberflächliche Dotierung eines mittels eines Dünnschichtverfahrens hergestellten Halbleiterbauelements, das anschließend von dem bei der Herstellung verwendeten Halbleiterträgersubstrat gelöst wird, eine Festkörperdiffusion von dem Halbleiterträgersubstrat zu der darauf abgeschiedenen Halbleiterschicht zu nutzen.

Dies führt unter anderem zu einer Vereinfachung des Herstellungsprozesses, da in der Halbleiterschicht nicht, wie herkömmlich üblich, nachträglich dotierte Bereiche eindiffundiert werden müssen bzw. bei der Abscheidung der Halbleiterschicht Dotandenkonzentrationen variiert werden müssen. Stattdessen kann die Halbleiterschicht kontinuierlich mit einer gleichbleibenden Dotandenkonzentration abgeschieden werden und aufgrund der bei der Herstellung gewählten Prozessparameter diffundieren Dotanden aus der Trennschicht in die abgeschiedene bzw. sich abscheidende Halbleiterschicht und bilden so gezielt dotierte Oberflächenbereiche, deren Dotierung vom gleichen oder von einem entgegengesetzten Leitungstyp bezogen auf die Dotierung der restlichen Halbleiterschicht sein kann und deren Dotierungskonzentration sich von derjenigen der restlichen Halbleiterschicht unterscheiden kann. Auf diese Weise können in der Halbleiterschicht p/n-, p/p⁺- oder n/n⁺-Strukturen erzeugt werden.

Vorteilhaft ist dabei ferner, dass der durch Festkörperdiffusion erzeugte gezielt dotierte Bereich des Halbleiterbauelementes eine verhältnismäßige geringe Oberflächendotierungskonzentration aufweist, die maximal derjenigen des Halbleiterträgersubstrates entspricht. Solch schwach dotierte Oberflächen sind z.B. insbesondere für Solarzellen bevorzugt, da sie besser passiviert werden können.

Ein weiterer Vorteil ist, dass das Halbleiterträgersubstrat mehrfach wieder verwendet werden kann.

Gemäß einer Ausführungsform weist das Herstellungsverfahren ferner eine nachträgliche Temperaturbehandlung anschließend an das Abscheiden der dotierten Halbleiterschicht auf. Unter einer Temperaturbehandlung kann dabei das Halten des Halbleiterträgersubstrats mitsamt der darauf abgeschiedenen Halbleiterschicht bei einer bestimmten Temperatur von beispielsweise mehr als 800 °C, vorzugsweise mehr als 900 °C und stärker bevorzugt mehr als 1.000 °C über eine bestimmte Prozessdauer hin verstanden werden. Je höher hierbei die Temperatur gewählt wird, umso schneller vollzieht sich die Festkörperdiffusion. Prozessdauern können, abhängig von der Prozesstemperatur, im Bereich von wenigen Minuten bis hin zu einigen Stunden betragen. Beispielsweise kann eine Prozessdauer von 60 Minuten bei einer Prozesstemperatur von 1100 °C zu einer Eindiffusion von dotierten Oberflächenbereichen führen, die eine für einen Emitter einer Solarzelle ausreichende Dotandenkonzentration aufweisen.

Gemäß einer weiteren Ausführungsform erfolgt das Abscheiden der Halbleiterschicht bei einer Temperatur von mehr als 800 °C, vorzugsweise mehr als 900 °C und stärker bevorzugt mehr als 1.000 °C. Indem die Temperatur beim Abscheiden der Halbleiterschicht möglichst hoch gewählt wird, kann es bereits während der Abscheidung zu einer signifikanten Festkörperdiffusion von Dotanden aus dem Halbleiterträgersubstrat in die sich abscheidende Halbleiterschicht kommen. Auf diese Weise kann eventuell die Notwendigkeit einer zusätzlichen Temperaturbehandlung zum Erreichen einer Festkörperdiffusion für ausreichend stark dotierte Oberflächenbereiche vermieden werden bzw. die Dauer einer solchen Temperaturbehandlung verkürzt werden.

Gemäß einer weiteren Ausführungsform wird für das Herstellungsverfahren ein Halbleiterträgersubstrat mit einer Dotierungskonzentration von mindestens 1x10¹⁸ cm⁻³, vorzugsweise mindestens 1x10¹⁹ cm⁻³ und stärker bevorzugt 1x10²⁰ cm³ in einem Oberflächen-nahen Bereich verwendet. Je höher die Dotierungskonzentration an der Oberfläche des Halbleiterträgersubstrats bzw. in einem Oberflächen-nahen Bereich z.B. wenige zehn oder hundert Nanometer unterhalb der Oberfläche ist, umso stärker wird die Festkörperdiffusion von dem Halbleiterträgersubstrat hin zur Halbleiterschicht ausfallen. Je nachdem, wie die hohe Dotierungskonzentration in dem Oberflächen-nahen Bereich des Halbleitersubstrats erzeugt wird, können sogar noch höhere Dotierungskonzentrationen von mehr als 5x10²⁰ cm³, vorzugsweise mehr als 1x10²¹ cm⁻³ erreicht werden, was sich vorteilhaft auf die Festkörperdiffusion auswirken kann. Die stark dotierten Oberflächen-nahen Bereiche können zum Beispiel durch eine herkömmliche POCl₃-Diffusion in dem Halbleiterträgersubstrat erzeugt werden, bevor die Halbleiterschicht auf dem Halbleiterträgersubstrat bzw. der daran befindlichen Trennschicht abgeschieden wird.

Gemäß einer weiteren Ausführungsform wird für das Herstellungsverfahren ein Halbleiterträgersubstrat verwendet, das eine im Wesentlichen homogene Grunddotierung aufweist. "Im Wesentlichen homogen" kann hierbei bedeuten, dass die Dotierung über das Halbleiterträgersubstrat hin um weniger als 50 %, vorzugsweise weniger als 20 % und stärker bevorzugt weniger als 5 % variiert. Mit anderen Worten befindet sich in dem Halbleiterträgersubstrat nicht wie bei der oben beschriebenen Ausführungsform ein lediglich Oberflächen-naher stark dotierter Bereich. Stattdessen weist das Halbleiterträgersubstrat über seine gesamte Dicke hin eine hohe Dotierung auf, die zu einer Leitfähigkeit von weniger als 50 mOhm-cm, vorzugsweise weniger als 10 mOhm-cm und stärker bevorzugt weniger als 3 mOhm-cm führt. Eine möglichst hohe Grunddotierung des Halbleiterträgersubstrats kann wiederum vorteilhaft für die Festkörperdiffusion sein. Es kann daher bevorzugt sein, ein Halbleiterträgersubstrat mit der maximal technisch erreichbaren Grunddotierung zu verwenden. Beispielsweise kann ein Siliziumträgersubstrat mit Bor-Dotierung verwendet werden, bei dem die Bor-Konzentration am Löslichkeitsmaximum gewählt ist. Alternativ können auch andere Trägersubstrate mit sonstigen Dotanden wie zum Beispiel Phosphor oder Gallium mit einer Dotierungskonzentration am Löslichkeitsmaximum verwendet werden.

Wenn gemäß einer weiteren Ausführungsform die Dotierung an einer Oberfläche des Halbleiterträgersubstrats und die Dotierung der abgeschiedenen bzw. sich abscheidenden Halbleiterschicht von entgegengesetztem Leitungstyp gewählt sind, kann durch Eindiffusion von Dotanden aus dem Trägersubstrat in die Halbleiterschicht ein pn-Übergang erzeugt werden zwischen einem sich durch die Eindiffusion bildenden Emitter und einer durch die restliche Halbleiterschicht gebildeten Basis.

Gemäß einer weiteren Ausführungsform kann das Herstellungsverfahren besonders vorteilhaft verwendet werden, wenn als Schichttransfer-Prozess das sogenannte PSI-Verfahren verwendet wird. Dieses Verfahren ist zum Beispiel in der DE 197 30 975 A1 detailliert beschrieben. Bei diesem Verfahren wird an einer Oberfläche eines Halbleiterträgersubstrats durch anodisches Ätzen ein poröses Schichtsystem erzeugt. Indem die beim Ätzen verwendeten Prozessparameter während des Ätzvorgangs variiert werden, kann erreicht werden, dass das poröse Schichtsystem eine untere Schicht mit einer hohen Porosität von zum Beispiel 40% oder mehr aufweist und darüber, das heißt hin zur Außenseite des Halbleiterträgersubstrats, eine obere Schicht mit einer niedrigeren Porosität von zum Beispiel 35 % oder weniger aufweist. Die hochporöse untere Schicht kann beim späteren Lösen der auf der oberen Schicht abgeschiedenen Halbleiterschicht als Sollbruchstelle dienen.

Um die Oberschicht weiter zu verdichten, wird das Halbleiterträgersubstrat nach dem anodischen Ätzen herkömmlicherweise meist einem sogenannten Bake- oder Annealschritt bei einer erhöhten Temperatur von beispielsweise 1100 °C und über eine Dauer von beispielsweise 30 Minuten unterzogen. Da bei einem solchen Annealschritt Dotanden aus der porösen Schicht in eine umgebende Atmosphäre ausdiffundieren, verringert sich hierbei jedoch die Dotierungskonzentration innerhalb der porösen Schicht. Wie oben beschrieben, kann eine geringere Dotierungskonzentration jedoch zu Nachteilen bei der Festkörperdiffusion führen. Es kann daher für das erfindungsgemäße Herstellungsverfahren vorteilhaft sein, den Annealschritt möglichst kurz zu halten, beispielsweise kürzer als 10 Minuten, vorzugsweise kürzer als 5 Minuten, bzw. ihn ganz wegzulassen.

Gemäß einer weiteren Ausführungsform umfasst das Herstellungsverfahren ferner ein Ausbilden von elektrisch leitfähigen Kontakten an Oberflächen der Halbleiterschicht. Diese Kontakte können vor und/oder nach dem Ablösen der Halbleiterschicht von dem Halbleiterträgersubstrat aufgebracht werden, zum Beispiel durch Aufdampfen. Beispielsweise können die Kontakte metallisch sein. Auf diese Weise kann eine Dünnschicht-Solarzelle gebildet werden. An einer einfallendem Licht zugewandten Seite der Solarzelle können die Kontakte zum Beispiel fingerförmig oder mit Hilfe transparenter Leiter ausgebildet werden. Optional können zusätzlich Dielektrikumschichten an der Oberfläche der Halbleiterschicht ausgebildet werden, um eine Oberflächenrekombination zu reduzieren.

Gemäß weiteren Aspekten der vorliegenden Erfindung wird ein Halbleiterbauelement bzw. eine Solarzelle vorgeschlagen, wie sie mit dem oben beschriebenen Herstellungsverfahren hergestellt werden können.

Es wird angemerkt, dass die Ausführungsformen, Merkmale und Vorteile der Erfindung hauptsächlich in Bezug auf das erfindungsgemäße Herstellungsverfahren beschrieben wurden. Ein Fachmann wird jedoch aus der vorangehenden und auch aus der nachfolgenden Beschreibung erkennen, dass, sofern dies nicht anders angegeben ist, die Ausführungsformen und Merkmale der Erfindung auch analog auf das erfindungsgemäße Halbleiterbauelement bzw. die erfindungsgemäße Solarzelle übertragen werden können. Insbesondere können die Merkmale der verschiedenen Ausführungsformen auch in beliebiger Weise untereinander kombiniert werden.

Weitere Merkmale und Vorteile der vorliegenden Erfindung werden dem Fachmann aus der nachfolgenden Beschreibung einer beispielhaften Ausführungsform, die jedoch nicht als die Erfindung beschränkend auszulegen ist, und unter Bezugnahme auf die begleitende Zeichnung ersichtlich.

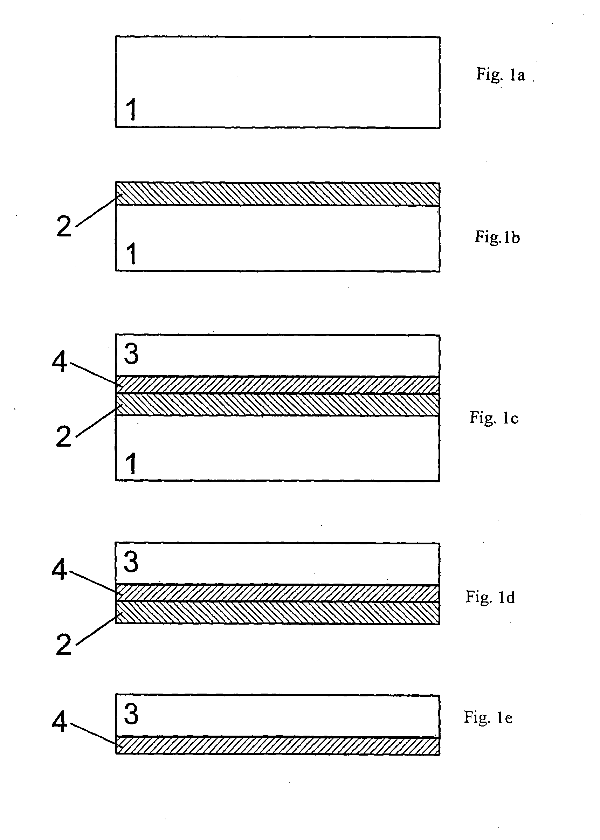

Fig. 1a bis 1e veranschaulichen schematisch eine Herstellungssequenz gemäß einer Ausführungsform der vorliegenden Erfindung.

Im Folgenden wird mit Bezug auf Fig. 1 eine Ausführungsform des erfindungsgemäßen Verfahrens vorgestellt, das die Erzeugung eines gezielt dotierten Bereichs in einem mittels einer Schichttransfer-Technologie hergestellten Halbleiterbauelements ermöglicht (Abb. 1a bis 1e).
a) Es wird ein Trägersubstrat (1) mit geeigneten Eigenschaften gewählt. Dabei kann es sich z.B. um eine Halbleiter-Scheibe oder ein Glas- oder Keramiksubstrat handeln. Das Trägersubstrat kann strukturiert und / oder mit Halbleiter- oder dielektrischen Schichten versehen sein bzw. lokale n- oder p-dotierte Bereiche aufweisen.
b) Das Trägersubstrat wird für den Schichttransferprozess präpariert (Abb. 1b), z.B. durch Erzeugung eines porösen Schichtsystems auf dessen Oberfläche (z.B. PSI-Prozess, Patent DE000019730975A1). Dieser Schritt ermöglicht das spätere Ablösen des Halbleiterbauelements. Anschließend können weitere Behandlungen folgen, beispielsweise das Einbringen der gewünschten Dotierstoffe in das Trägersubstrat (1) und / oder den für den Schichttransfer präparierten Bereich (2) des Trägersubstrats.
c) Die Halbleiterschicht (3) wird aufgewachsen (z.B. durch CVD). Während des Aufwachsens, oder durch eine nachträglichen Temperaturbehandlung, wandern Dotierstoffe aus dem Trägersubstrat (1) und / oder aus dem für den Schichttransfer präparierten Bereich des Trägersubstrats (2) in die Halbleiterschicht (3) und erzeugen einen gezielt dotierten Bereich (4) in der Halbleiterschicht (Abb1c).
d) Die aufgewachsene Halbleiterschicht (3) inklusive des gezielt dotierten Bereichs (4) wird vom Trägersubstrat abgelöst. Dabei verbleibt evtl. ein Teil des Trägersubstrats (2) an der abgelösten Halbleiterschicht (Abb. 1d).
e) Die evtl. vorhandenen Reste des Trägersubstrats (2) werden entfernt, sofern dies für nachfolgende Prozesse notwendig ist (Abb. 1e).

Als Resultat erhält man ein Halbleiterbauelement, welches einen gezielt dotierten Bereich (4) auf der dem Trägersubstrat zugewandten Seite aufweist. Kennzeichnend ist, dass der für die Erzeugung des gezielt dotierten Bereichs (4) benötigte Dotierstoff vom Trägersubstrat (1) bzw. Bereichen des Trägersubstrats (2) zur Verfügung gestellt wird und nicht während des Schichtwachstums über den Wachstumsprozess (z.B. bei CVD über die Gasphase) bereitgestellt werden muss. Dies ermöglicht eine schnelle und einfache Prozessführung für das Schichtwachstum, da während des Schichtwachstums die Parameter der Abscheidung (Insbesondere Art und Konzentration der Dotierung) nicht variiert werden müssen. Dadurch wird die Herstellung von Halbleiterbauelementen, die einen solchen dotierten Bereich aufweisen, vereinfacht.

Abschließend wird der Hintergrund und Merkmale der Erfindung noch einmal mit anderen Worten erläutert:

Es besteht die Möglichkeit, die Aus-Diffusion von Dotierstoffen aus dem Trägersubstrat oder anderen Quellen und die erneute Einbringung dieser Dotierstoffe in die wachsende Schicht zu nutzen. Findet der Transport der Dotierstoffe über die Gasphase statt, wird dieses Phänomen als "Autodoping" bezeichnet. Diffundieren die Dotierstoffe dagegen aus angrenzenden Schichten oder aus dem Trägersubstrat in die wachsende Schicht, spricht man von "Festkörperdiffusion". Die Aus-Diffusion von Dotierstoffen ist bei Epitaxie-Prozessen gewöhnlich nicht erwünscht. Es gibt jedoch auch Anwendungen, die dieses Phänomen kontrollieren und gezielt nutzen um ein angestrebtes Dotierprofil in der aufgewachsenen Schicht zu erzeugen (Siehe z.B. B. M. Abdurakhmanov und R. R. Bilyalov, Semicond. Sci. Technol. 11 (1996) 921-926 und US-Patente US4925809, US4466171, US4379726, US4170501, US4132573 und US4032372). Dies ist auch bei dem vorliegenden erfindungsgemäßen Verfahren der Fall.

Die vorliegende Erfindung bezieht sich auf die Herstellung eines Halbleiterbauelements, z.B. einer Solarzelle, unter Verwendung einer Schichttransfertechnik. Die Herstellung umfasst unter anderem die Generierung einer gewünschten räumlichen Dotierstoff-Verteilung zur Erzeugung n-leitender und/oder p-leitender Bereiche in der Halbleiterschicht. Die dafür benötigten Dotierstoffe müssen entweder während des Schichtwachstums oder durch nachfolgende Prozesse in den Halbleiterschicht eingebracht werden.

Die vorliegende Erfindung ermöglicht die Erzeugung eines gezielt dotierten Bereichs vom Leitungstyp n oder p in einer Halbleiterschicht. Die Herstellung der Halbleiterschicht erfolgt mittels einer Schichttransfertechnik ( wie sie z.B. als PSI-Prozess bekannt ist und in der deutschen Patentanmeldung DE 000019730975 A1 beschrieben ist). Die Halbleiterschicht wird dabei auf einem Trägersubstrat abgeschieden. Das Trägersubstrat wird zuvor derart präpariert, dass die aufgewachsene Halbleiterschicht kontrolliert vom Trägersubstrat abgelöst werden kann.

Eine Aufgabe der Erfindung kann in der möglichst einfachen Herstellung eines gezielt dotierten Bereichs bestehen. Ziel ist es, die Erzeugung des gezielt dotierten Bereichs zu ermöglichen, ohne dass hierfür neben dem Wachstum der Halbleiterschicht weitere nachfolgende Prozesse erforderlich sind. Weiterhin soll der Wachstums-Prozess selbst so geführt werden, dass insbesondere Art und Konzentration der Dotierung der aufgewachsenen Halbleiterschicht während des Schichtwachstums nicht variiert werden müssen. Dies soll eine einfache Prozessführung erlauben.

Gemäß bevorzugten Ausführungsformen nutzt die vorliegende Erfindung das oben beschriebene Phänomen der Aus-Diffusion von Dotierstoffen bei Hochtemperaturprozessen (Festkörperdiffusion), um die Aufgabenstellung zu lösen. Dabei fungiert das Trägersubstrat bzw. darauf befindliche Schichten oder Bereiche als Quelle für Dotierstoffe, die von der Quelle in die aufgewachsene Halbleiterschicht diffundieren. Dieser Diffusionsprozess vollzieht sich während der Abscheidung der Halbleiterschicht und / oder bei einer nachträglichen Temperaturbehandlung. Durch diese Aus-Diffusion entsteht auf der dem Substrat zugewandten Seite der Halbleiterschicht ein gezielt dotierter Bereich für dessen Herstellung weder ein separater Prozess noch eine Variation der zugeführten Dotierstoffe während des Wachstumsprozesses notwendig ist. Der gezielt dotierte Bereich entsteht also "automatisch" während des Schichtwachstums und / oder durch nachträgliche Temperaturbehandlung. Dadurch wird dessen Herstellung stark vereinfacht.

Insbesondere kann durch geeignete Wahl des von der Quelle zur Verfügung gestellten Dotierstoffs (z.B. Bor oder Phosphor) der Leitungstyp des gezielt dotierten Bereichs zu n-Typ oder p-Typ gewählt werden. Der Leitungstyp der aufgewachsenen Halbleiterschicht kann durch die Zugabe von Dotierstoffen während des Schichtwachstums ebenfalls zu n-Typ oder p-Typ eingestellt werden. Somit lassen sich sowohl pn-Übergänge als auch Übergänge von einer niedrigen zu einer hohen Dotierkonzentration (p/p+ oder n/n+) realisieren.

Die vorliegende Erfindung zeichnet sich gegenüber den oben genannten Erfindungen (US-Patente US4925809, US4466171, US4379726, US4170501, US4132573 und US4032372) dadurch aus, dass die Nutzung der Aus-Diffusion von Dotierstoffen aus dem Trägersubstrat in die wachsenden Halbleiterschicht einerseits kombiniert wird mit einer Schichttransfertechnik, die andererseits das spätere Ablösen der gewachsenen Halbleiterschicht inklusive des entstandenen gezielt dotierten Bereichs ermöglicht. Dadurch wird die Seite der Halbleiterschicht zugänglich auf der sich der erzeugte gezielt dotierte Bereich befindet. Dies ermöglicht die Behandlung der Oberfläche dieses Bereichs z.B. zur Oberflächenpassivierung und elektrischen Kontaktierung. Ein weiterer Vorteil der vorliegenden Erfindung liegt in der Wiederverwendbarkeit des Trägersubstrats nicht nur als Wachstumssubstrat sondern auch als Quelle für Dotierstoffe. Auch in diesem Punkt, der Wiederverwendbarkeit der Dotierstoffquelle, unterscheidet sich die vorliegende Erfindung von oben genannten Erfindungen.

Ausführungsbeispiele der Erfindung können gemäß den nachfolgenden Vorschlägen beschrieben werden:
1) Verfahren zur Herstellung eines gezielt dotierten Bereichs in einem mittels eines Schichttransfer-Verfahrens hergestellten Halbleiterbauelement, dadurch gekennzeichnet, dass das Trägersubstrat und/oder ein Teil oder Bereich des Substrates bzw. eine auf das Trägersubstrat aufgebrachte Schicht als Quelle für Dotierstoffe genutzt wird, wobei während des Wachsens der Halbleiterschicht und/oder durch nachträgliche Temperaturbehandlung ein gezielt dotierter Bereich in der wachsenden Schicht geschaffen wird. Das Trägersubstrat kann als DotierstoffQuelle wieder verwendet werden.
2) Verfahren zur Herstellung eines auf Schichttransfer basierenden Halbleiterbauelementes nach Vorschlag 1, dadurch gekennzeichnet, dass es sich bei der Schicht und dem gezielt dotierten Bereich der Schicht um einen pn-Übergang bzw. einen n/n+ oder p/p+-Übergang handelt.
3) Verfahren zur Herstellung eines auf Schichttransfer basierenden Halbleiterbauelementes nach Vorschlag 1, dadurch gekennzeichnet, dass das Halbleiterbauelement eine Solarzelle ist.
4) Verfahren zur Herstellung eines auf Schichttransfer basierenden Halbleiterbauelementes nach Vorschlag 1, dadurch gekennzeichnet, dass für den Schichttransfer der PSI-Prozess (Patent DE000019730975A1) verwendet wird.
5) Verfahren zur Herstellung eines auf Schichttransfer basierenden Halbleiterbauelementes nach Vorschlag 1, dadurch gekennzeichnet, dass die Halbleiterschicht mittels Gasphasenepitaxie (CVD), Flüssigphasenepitaxie (LPE), Ionen-assistierter Abscheidung (IAD), oder einem anderen entsprechenden Verfahren gewachsen wird.
6) Halbleiterbauelement, gekennzeichnet dadurch, dass bei der Herstellung ein Verfahren nach Vorschlag 1, 2, 3, 4, oder 5 verwendet wurde.

**Bezugszeichenliste**

| | |
|---|---|
| 1 | Trägersubstrat |
| 2 | Für den Schichttransfer präparierter Bereich des Trägersubstrats |
| 3 | Aufgewachsene Halbleiterschicht |
| 4 | Durch Aus-Diffusion erzeugter, gezielt dotierter Bereich der aufgewachsenen Halbleiterschicht |

## Patentansprüche

1. Verfahren zum Herstellen eines Halbleiterbauelementes mit einem gezielt dotierten Oberflächenbereich (4), aufweisend:
Bereitstellen eines dotierten Halbleiterträgersubstrates (1);
Erzeugen einer Trennschicht (2) an einer Oberfläche des Halbleiterträgersubstrates;
Abscheiden einer dotierten Halbleiterschicht (3) über der Trennschicht;
Lösen der abgeschiedenen Halbleiterschicht von dem Halbleiterträgersubstrat;
wobei Prozessparameter, die zumindest einen Parameter aus der Gruppe Prozesstemperatur, Prozesstemperaturverlauf und Prozessdauer einschließen, so gewählt werden, dass durch Festkörperdiffusion Dotanden aus der Trennschicht in die abgeschiedene Halbleiterschicht diffundieren, um den gezielt dotierten Oberflächenbereich zu bilden, wobei der gezielt dotierte Oberflächenbereich eine im Vergleich zur restlichen Halbleiterschicht verhältnismäßig starke Dotierung aufweist, sodass der Oberflächenbereich einen Schichtwiderstand von weniger als 500 Ohm/square aufweist.

2. Verfahren nach Anspruch 1, wobei als Trennschicht eine poröse Schicht an dem Halbleiterträgersubstrat erzeugt wird.

3. Verfahren nach Anspruch 1 oder 2, ferner aufweisend eine nachträgliche Temperaturbehandlung anschließend an das Abscheiden der dotierten Halbleiterschicht.

4. Verfahren nach Anspruch 3, wobei das Halbleiterträgersubstrat während der Temperaturbehandlung zusammen mit der darauf abgeschiedenen Halbleiterschicht bei einer Temperatur von mehr als 800°C gehalten wird.

5. Verfahren nach einem der vorangehenden Ansprüche, wobei das Abscheiden der Halbleiterschicht bei einer Temperatur von mehr als 800°C erfolgt.

6. Verfahren nach einem der vorangehenden Ansprüche, wobei das Halbleiterträgersubstrat in einem Oberflächen-nahen Bereich eine Dotierungskonzentration von mindestens 1*10¹⁸ cm⁻³ aufweist.

7. Verfahren nach einem der vorangehenden Ansprüche, wobei das Halbleiterträgersubstrat eine im Wesentlichen homogene Grunddotierung für eine Leitfähigkeit von weniger als 50 Milliohm-Zentimeter aufweist.

8. Verfahren nach einem der vorangehenden Ansprüche, wobei die Dotierung an einer Oberfläche des Halbleiterträgersubstrates und die Dotierung der abgeschiedenen Halbleiterschicht vom entgegengesetztem Leitungstyp sind.

9. Verfahren nach einem der vorangehenden Ansprüche 1 bis 7, wobei die Dotierung an einer Oberfläche des Halbleiterträgersubstrates und die Dotierung der abgeschiedenen Halbleiterschicht vom gleichen Leitungstyp sind.

10. Verfahren nach einem der vorangehenden Ansprüche, wobei als Schichttransfer-Verfahren ein PSI-Prozess verwendet wird.

11. Verfahren nach einem der vorangehenden Ansprüche, wobei die Halbleiterschicht mittels Gasphasenepitaxie, Flüssigphasenepitaxie oder Ionen-assistierter Abscheidung abgeschieden wird.

12. Verfahren nach einem der vorangehenden Ansprüche, ferner aufweisend ein Ausbilden von elektrisch leitfähigen Kontakten an Oberflächen der Halbleiterschicht zum Bilden einer Solarzelle.

## Claims

1. Method for manufacturing a semiconductor element having a specifically doped surface region (4), comprising:
- providing a doped semiconductor carrier substrate (1);
- producing a partition layer (2) on a surface of the semiconductor carrier substrate;
- depositing a doped semiconductor layer (3) over the partition layer;
- removing the deposited semiconductor layer from the semiconductor carrier substrate;
wherein process parameters, which include at least one parameter from the group including process temperature, process temperature progression and process duration, are selected in such a way that dopants diffuse from the partition layer into the deposited semiconductor layer by solid state diffusion, so as to form the specifically doped semiconductor region, the specifically doped surface region having relatively heavy doping by comparison with the rest of the semiconductor layer, in such a way that the surface region has a sheet resistance of less than 500 ohms/square.

2. Method according to claim 1, wherein a porous layer is produced on the semiconductor carrier substrate as the partition layer.

3. Method according to either claim 1 or claim 2, further comprising subsequent heat treatment after the deposition of the doped semiconductor layer.

4. Method according to claim 3, wherein the semiconductor carrier substrate, together with the semiconductor layer deposited thereon, is kept at a temperature of more than 800 °C during the heat treatment.

5. Method according to any one of the preceding claims, wherein the semiconductor layer is deposited at a temperature of more than 800 °C.

6. Method according to any one of the preceding claims, wherein the semiconductor carrier substrate has a doping concentration of at least 1*10¹⁸ cm⁻³ in a region close to the surface.

7. Method according to any one of the preceding claims, wherein the semiconductor carrier substrate has substantially homogeneous basic doping for a conductivity of less than 50 milliohm centimeters.

8. Method according to any one of the preceding claims, wherein the doping on a surface of the semiconductor carrier substrate and the doping of the deposited semiconductor layer are of opposite conduction types.

9. Method according to any one of claims 1 to 7, wherein the doping on a surface of the semiconductor carrier substrate and the doping of the deposited semiconductor layer are of the same conduction type.

10. Method according to any one of the preceding claims, wherein a PSI process is used as the layer transfer method.

11. Method according to any one of the preceding claims, wherein the semiconductor layer is deposited by gas phase epitaxy, liquid phase epitaxy or ion-assisted deposition.

12. Method according to any one of the preceding claims, further comprising forming electrically conductive contacts on surfaces of the semiconductor layer so as to form a solar cell.

## Revendications

1. Procédé de fabrication d'un composant semi-conducteur avec une zone dopée superficielle ciblée (4), présentant :
- la fourniture d'un substrat semi-conducteur porteur dopé (1) ;
- la réalisation d'une couche de séparation (2) sur une surface du substrat semi-conducteur porteur ;
- la déposition d'une couche semi-conductrice dopée (3) au dessus de la couche de séparation ;
- la libération de la couche semi-conductrice déposée du substrat semi-conducteur porteur ;
des paramètres de traitement, qui comprennent au moins un paramètre appartenant au groupe comprennanttempérature de traitement, cours de température de traitement et durée de traitement, étant choisis de telle sorte que des dopants se diffusent, par diffusion de solides, depuis la couche de séparation dans la couche semi-conductrice déposée pour constituer la zone dopée superficielle ciblée, la zone dopée superficielle ciblée présentant un dopage relativement fort par rapport au reste de la zone dopée superficielle, de telle sorte que la zone superficielle présente une résistance de couche de moins de 500 Ohms/carré.

2. Procédé selon la revendication 1, une couche poreuse étant réalisée en tant que couche de séparation sur le substrat semi-conducteur porteur.

3. Procédé selon la revendication 1 ou 2, présentant en outre un traitement thermique ultérieur suite à la déposition de la couche semi-conductrice dopée.

4. Procédé selon la revendication 3, le substrat semi-conducteur porteur étant maintenu pendant le traitement thermique, conjointement avec la couche semi-conductrice déposée sur ce dernier, à une température de plus de 800 °C.

5. Procédé selon l'une des revendications précédentes, la déposition de la couche semi-conductrice étant effectuée à une température de plus de 800 °C.

6. Procédé selon l'une des revendications précédentes, le substrat semi-conducteur porteur présentant, dans une zone à proximité de la surface, une concentration de dopage d'au moins 1 * 10¹⁸ cm⁻³.

7. Procédé selon l'une des revendications précédentes, le substrat semi-conducteur porteur présentant un dopage de base essentiellement homogène pour une conductivité de moins de 50 milliohms-centimètre.

8. Procédé selon l'une des revendications précédentes, le dopage à une surface du substrat semi-conducteur porteur et le dopage de la couche semi-conductrice déposée étant d'un type de conduction opposé.

9. Procédé selon l'une des revendications précédentes 1 à 7, le dopage sur une surface du substrat semi-conducteur porteur et le dopage de la couche semi-conductrice déposée étant d'un même type de conduction.

10. Procédé selon l'une des revendications précédentes, un processus PSI étant utilisé comme procédé de transfert de couche.

11. Procédé selon l'une des revendications précédentes, la couche semi-conductrice étant isolée au moyen d'une épitaxie en phase gazeuse, d'une épitaxie en phase liquide ou d'une isolation assistée par faisceau d'ions.

12. Procédé selon l'une des revendications précédentes, présentant en outre un développement de contacts électriquement conducteurs à des surfaces de la couche semi-conductrice pour la formation d'une photopile.
